# FASCICULE DE BREVET EUROPEEN

(11) **EP 0 611 184 B1**
(45) Date de publication et mention de la délivrance du brevet: **16.04.1997**
(21) Numéro de dépôt: 94400196.5
(22) Date de dépôt: 31.01.1994
(51) Int. Cl.: A45D 33/34, A45D 33/12, A45D 33/00

(54) **Ensemble applicateur d'un produit cosmétique**
Auftragseinheit eines kosmetischen Produktes
Applicator unit for a cosmetic product

(30) Priorité: 10.02.1993 FR 9301453
(43) Date de publication de la demande: 17.08.1994
(73) Titulaire: L'OREAL, 75008 Paris (FR)
(72) Inventeur: Gueret, Jean-Louis, F-75018 Paris (FR)
(74) Mandataire: Peuscet, Jacques

(56) Documents cités:
- FR-A- 512 263
- FR-A- 1 476 039
- FR-A- 1 524 192
- US-A- 2 276 047
- US-A- 4 147 441
- US-A- 4 368 184
- DATABASE WPI Week 8030, Derwent Publications Ltd., London, GB; AN 80-52377C & JP-A-55 076 612 (NAKAMURA)

## Description

La présente invention concerne un ensemble applicateur d'un produit cosmétique, comme par exemple un produit de maquillage pulvérulent, comportant un organe applicateur et un réservoir contenant le produit.

Il est bien connu que le maquillage à l'aide d'un produit, comme par exemple la poudre de riz, s'effectue généralement en prélevant le produit dans un réservoir, notamment une boîte, à l'aide d'un applicateur, qui est constitué par un pinceau ou par une houpette en matériau souple, notamment en mousse souple de matière plastique, la mousse de matière plastique ayant été éventuellement floquée.

Ce mode de maquillage présente l'inconvénient que le récipient ou boîte et l'applicateur sont indépendants et qu'il est possible d'égarer l'un de ces éléments. Par ailleurs, lorsque le produit est une poudre contenue dans une boîte, la poudre risque de se répandre quand l'utilisateur transporte la boîte, si celle-ci n'est pas suffisamment étanche ou plus particulièrement de se répandre au moment où l'utilisateur ouvre la boîte pour prélever le produit. En outre, lors du prélèvement du produit, une partie de celui-ci est souvent répandue par l'utilisateur. De plus, lorsque le produit est une poudre libre celle-ci a tendance à voler.

On a proposé dans FR-A-512 263 d'utiliser, pour prélever un produit, un récipient comportant une ouverture fermée par un organe distributeur monté de manière à pouvoir tourner et disposé de façon à se trouver en partie à l'intérieur et en partie à l'extérieur du récipient, la surface de l'applicateur étant en partie à l'intérieur du récipient et en partie à l'extérieur. L'étanchéité du récipient peut être obtenue à l'aide de lames souples qui appuient dans une direction radiale sur la surface de l'applicateur ce qui permet, dans une certaine mesure, de compacter le produit prélevé.

La présente invention a pour objet un ensemble applicateur d'un produit cosmétique, comportant un réservoir contenant le produit et un organe applicateur, constitué d'au moins un segment circulaire en matériau souple, solidaire en rotation d'un axe par lequel il est monté en rotation dans un carter, solidaire du réservoir contenant le produit, ledit axe pouvant être actionné en rotation de l'extérieur, ensemble dans lequel le carter comporte deux ouvertures, une ouverture intérieure, mettant en communication le réservoir et le carter, et une ouverture extérieure, s'ouvrant vers l'extérieur, l'organe applicateur étant monté mobile entre au moins deux positions, une position permettant le contact du segment de l'organe applicateur avec le produit contenu dans le réservoir et une position où ledit segment chargé de produit est au moins partiellement mis au droit de l'ouverture extérieure pour lui permettre d'émerger du carter et de servir pour l'application du produit, l'organe applicateur ayant tendance en passant, par rotation, de l'une à l'autre desdites positions à tasser le produit qui se trouve ainsi compacté sur l'organe applicateur caractérisé par le fait que le segment dudit organe applicateur est au moins en partie comprimé dans la direction de l'axe de rotation dans une zone comprise entre les ouvertures intérieure et extérieure.

Le produit cosmétique peut être une poudre de maquillage, grasse ou sèche ; ce peut être aussi une suspension pigmentaire ou particulaire sous forme de pâte plus ou moins fluide.

Avantageusement, le carter est constitué par une enveloppe dont les parois latérales sont, au droit de ladite zone, à une distance l'une de l'autre inférieure à l'épaisseur axiale du segment de l'organe applicateur souple, ladite épaisseur étant mesurée lorsque l'organe applicateur est libre, au repos ; en variante, au moins un plateau de pression est disposé axialement entre une paroi latérale de l'enveloppe et le segment de l'organe applicateur ; avantageusement, le plateau de pression est solidaire d'un bouton-poussoir traversant la paroi latérale de l'enveloppe et accessible de l'extérieur par l'utilisateur.

Pour faciliter le compactage du produit, l'ouverture inférieure, aménagée sur le bord inférieur de l'enveloppe, comporte des échancrures ménagées dans les parois latérales de l'enveloppe, le bord de l'ouverture inférieure ayant la forme d'un biseau incliné de l'extérieur vers l'intérieur sur tout le pourtour de l'ouverture inférieure, ledit segment de l'organe applicateur étant disposé au droit desdites échancrures. De cette façon, l'ouverture constitue en quelque sorte un entonnoir dans lequel le produit, notamment lorsqu'il est pulvérulent, a tendance à se tasser par gravité lorsque l'ensemble applicateur est dans la position où le réservoir est placé en haut ; de plus, l'organe applicateur, en tournant, a tendance à tasser le produit par effet de coin : de cette façon, le produit, notamment poudreux, est compacté sur l'organe applicateur. On peut prélever ainsi une quantité supérieure de produit, et lorsque la portion de l'organe applicateur chargée arrive par rotation au niveau de l'ouverture extérieure du carter, le produit, s'il est poudreux, est compacté et n'a pratiquement pas tendance à voler. L'ouverture intérieure du carter peut être aménagée de telle façon qu'un seul côté de l'organe applicateur se soit chargé de produit ; ainsi l'autre côté peut servir d'estompe.

De préférence, l'ensemble applicateur comporte un couvercle monté sur le carter de façon à protéger le segment de l'organe applicateur disposé à l'extérieur du carter.

L'ensemble selon l'invention fonctionne de la façon suivante : l'utilisateur prend l'ensemble applicateur dans la position où le réservoir est placé vers le haut, de façon que l'organe applicateur soit en contact avec le produit pulvérulent, qui est venu par gravité au contact de l'organe applicateur grâce à l'ouverture intérieure du carter mettant en communication le carter et le réservoir. L'utilisateur fait ensuite tourner l'organe applicateur dans le carter, jusqu'à ce que le segment, qui était en contact avec le produit dans le réservoir, apparaisse dans l'ouverture extérieure du carter. Au cours de cette rotation, le segment traverse la zone de contrainte et le produit est compacté sur l'organe applicateur. L'utilisateur applique alors le produit, sur le visage par exemple, à l'aide du segment dégagé par ladite ouverture extérieure. Avec l'ensemble selon l'invention, l'utilisateur ne risque pas de répandre le produit lors du prélèvement dans le réservoir, et, lorsque le produit est une poudre, la poudre prélevée ne risque pas de voler dans l'atmosphère.

Selon une première variante, l'organe applicateur peut être entièrement constitué en une mousse souple, notamment une mousse de de matériau plastique à cellules ouvertes ou fermées. Selon une autre variante, l'organe applicateur est réalisé, notamment par injection, en un matériau thermoplastique semi-souple ayant subi un traitement de surface de flockage. Selon une troisième variante, l'organe applicateur est constitué par un moyeu circulaire en matériau rigide, sur lequel est fixé un anneau en mousse souple. Lorsque la surface de l'organe applicateur est réalisé en mousse souple, elle peut être, au moins partiellement, floquée, de façon à améliorer le contact avec la peau lors de l'application et à permettre d'estomper le plus facilement possible le produit après application. Le bord extérieur de l'organe applicateur en mousse souple peut avoir, en section par un plan axial, des formes variables adaptées à son utilisation lors de l'application : cette forme peut être arrondie, triangulaire ou formée de deux lèvres. Selon une quatrième variante, l'organe applicateur est constitué par un moyeu en matériau rigide sur lequel des poils souples sont fixés radialement.

Comme indiqué ci-dessus, l'organe applicateur peut être actionné de l'extérieur par l'utilisateur. De préférence, le dispositif d'actionnement est constitué par au moins une molette fixée à une extrémité de l'axe de rotation et disposée, au moins partiellement, à l'extérieur du carter. De préférence, un dispositif approprié évite toute rotation relative de l'organe applicateur par rapport à l'axe. En variante, le dispositif d'actionnement est le couvercle lui-même monté à rotation et solidaire en rotation de l'organe applicateur ; selon une autre variante, c'est un levier extérieur permettant une démultiplication de l'effort à fournir pour vaincre la mise en contrainte de l'organe applicateur.

L'axe de rotation est, de préférence, constitué de deux éléments emboîtables qui s'appuient, après emboîtage, sur la paroi latérale du carter ou sur un élément solidaire de la paroi latérale du carter, pour éviter, après l'emboîtage, tout jeu de l'axe en translation. après l'emboîtage.

Avantageusement, l'enveloppe est en deux pièces et l'organe applicateur est monté de manière amovible en sorte qu'il est interchangeable.

Les deux ouvertures du carter sont, de préférence, disposées perpendiculairement à l'axe longitudinal du carter. Les bords de l'ouverture extérieure, dégageant la partie de l'organe applicateur chargée en produit et servant à l'application, sont, de préférence, situés dans un plan perpendiculaire à l'axe longitudinal du carter. L'ouverture intérieure mettant en communication le réservoir et le carter comporte, de préférence, une échancrure dans la paroi latérale du carter ayant une forme curviligne, trapézoïdale ou rectangulaire.

Le réservoir est fixé par tout moyen connu sur le carter; sa fixation est, de préférence, amovible de façon à pouvoir fixer des réservoirs différents sur un même carter, soit pour recharger l'ensemble en produit, soit pour modifier la nature du produit utilisé.

Le réservoir peut avoir une forme quelconque, symétrique ou non ; il suffit qu'il puisse s'adapter sur le carter.

La description donnée ci-dessous, à titre illustratif et non limitatif, de plusieurs modes de réalisation permettra, en référence au dessin annexé, de mieux comprendre l'invention.

Sur ce dessin :
- la figure 1 est une vue de face d'un premier mode de réalisation de l'ensemble selon la présente invention ;
- la figure 2 représente en coupe transversale l'ensemble de la figure 1;
- la figure 3 est une coupe selon III-III de la figure 2 ;
- les figures 4 à 7 représentent différents modes de réalisation de l'organe applicateur selon l'invention ;
- la figure 8 représente schématiquement, en vue de face, un autre mode de réalisation d'un ensemble selon la présente invention ;
- la figure 9 est une coupe selon IX-IX de la figure 8, à plus grande échelle ;
- la figure 10 est une coupe partielle, selon X-X de la figure 9, à échelle différente ;
- la figure 11 est une vue partielle éclatée d'un autre mode de réalisation d'un ensemble selon l'invention ;
- la figure 12 est une vue en coupe selon XII-XII de la figure 11 ;
- la figure 13 est analogue à la figure 8, mais représente une variante ;
- la figure 14 est analogue à la figure 13, mais représente une autre variante ;
- la figure 15 est une vue éclatée montrant un détail de montage de la variante de la figure 14, à plus grande échelle ;
- la figure 16 est une vue en coupe partielle montrant le fonctionnement d'un ensemble selon l'invention, expliqué à propos de la variante des figures 8 à 10, la coupe étant faite circonférentiellement et perpendiculairement au plan des figures 8 et 10 ;
- la figure 17 est analogue à la figure 16 mais correspond à une variante d'enveloppe ;
- la figure 18 est une coupe partielle analogue à la figure 9 mais représente une variante.

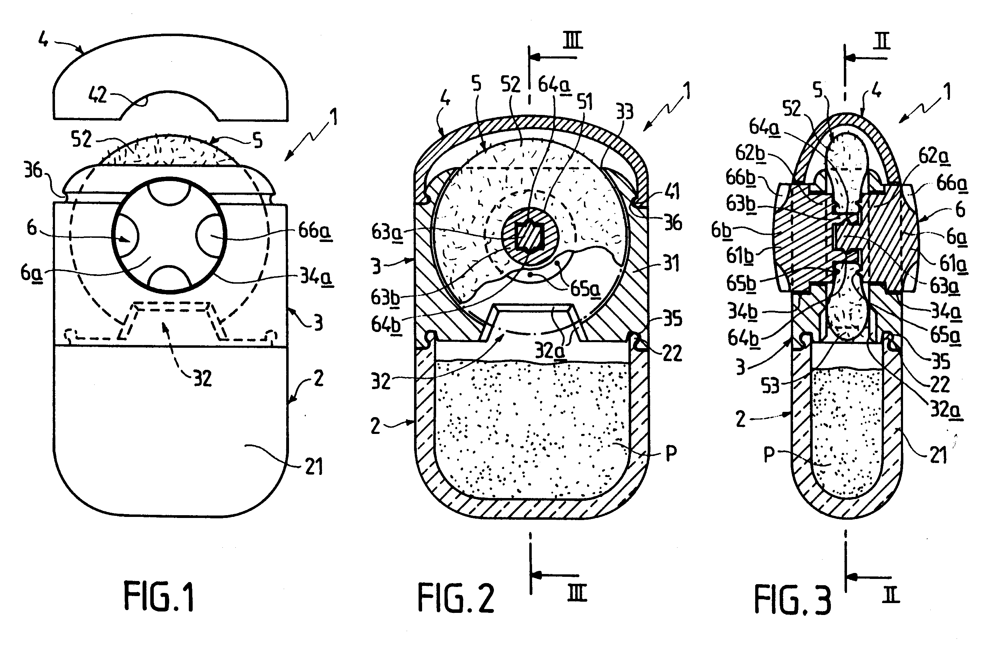

L'ensemble applicateur représenté sur les figures 1 à 3 est désigné dans son ensemble par la référence 1. Il se compose d'un réservoir 2, d'un carter 3 et d'un couvercle 4. Le carter 3 porte à rotation autour d'un axe 6 un disque applicateur 5. Le réservoir 2 est un cylindre de section quasi rectangulaire limité par deux parois latérales parallèles planes 21 et ouvert à sa partie supérieure (dans la position représentée sur les figures 1 à 3). Le bord du réservoir est muni d'un dispositif de fixation 22 par claquage, coopérant avec un dispositif 35 correspondant du carter 3. Le réservoir contient un produit pulvérulent P, éventuellement mélangé à un liant de façon à faciliter le compactage ; le réservoir 2 peut être, bien entendu, conditionné à la manière d'une recharge.

Le carter 3 est constitué par une enveloppe 31 dont les parois latérales extérieures sont dans le prolongement de celles du réservoir 2 . Dans ce carter 3 est ménagé un espace cylindrique, à section circulaire, coaxial avec le disque applicateur 5 et l'axe 6, ayant des dimensions lui permettant d'épouser étroitement la forme du disque applicateur 5. Sur le bord inférieur de l'enveloppe 31 du carter, est ménagée une ouverture 32 intérieure qui met le réservoir 2 en communication avec l'espace cylindrique intérieur de l'enveloppe 31 du carter 3. Cette ouverture 32 comporte des échancrures, ménagées dans les parois latérales planes de l'enveloppe 31, qui ont une forme trapézoïdale. Sur tout le pourtour de l'ouverture 32, le bord 32a a la forme d'un biseau incliné de l'extérieur vers l'intérieur. A sa partie supérieure, le carter 3 présente une ouverture 33 extérieure de forme rectangulaire. Dans l'enveloppe 31 sont ménagées deux fenêtres circulaires 34a et 34b pour le passage et la fixation de l'axe de rotation 6 du disque applicateur 5, comme expliqué ci-après. A l'intérieur de la paroi de l'enveloppe 31, ces fenêtres 34a, 34b sont constituées de deux sections de diamètres différents, séparées par un épaulement, la section de plus faible diamètre débouchant dans l'espace cylindrique à section circulaire. Sur la partie supérieure du carter, autour de l'ouverture extérieure 33, est prévu un dispositif de fixation du couvercle 4 constitué d'un dispositif de claquage 36 coopérant avec un dispositif correspondant 41 du couvercle 4.

Le disque applicateur 5 est, dans le mode de réalisation représenté aux figures 1 à 3, entièrement en mousse souple entièrement floquée. Il est muni en son centre d'une ouverture circulaire 51 pour le passage de l'axe 6. Le disque 5 a des dimensions telles que, lorsqu'il est monté dans le carter 3, un segment 52 émerge du carter 3 à travers l'ouverture 33 et qu'un segment 53 du disque est disposé dans l'ouverture 32 au droit des échancrures trapézoïdales.

L'axe 6 est constitué de deux éléments 6a et 6b s'emboîtant l'un dans l'autre. Chacun de ces éléments est formé de trois parties successives de section décroissante : une molette 61a, 61b de section transversale circulaire, un flasque 62a, 62b de section transversale circulaire et une tige 63a, 63b. La tige 63a de l'élément 6a est pleine et a, en section transversale, une forme carrée. Elle s'emboîte dans la tige 63b creuse qui comporte une empreinte ayant une section carrée correspondant à celle de la tige 63a. La fixation de la tige 63a dans la tige 63b se fait par un système double à nervure 64a et rainure 64b de claquage. Les flasques 62a et 62b portent des picots axiaux 65a et 65b qui s'enfoncent dans la mousse souple constituant le disque 5 et qui empêchent toute rotation relative du disque 5 par rapport à l'axe 6 lorsque l'ensemble est monté. Les flasques 62a et 62b sont partiellement disposés dans la section de plus faible diamètre des fenêtres 34a et 34b. Les molettes 61a et 61b sont partiellement disposées à l'extérieur des fenêtres 34a, 34b dans la section de plus grand diamètre desdites fenêtres et s'appuient sur l'épaulement entre les deux sections de diamètre différent des fenêtre 34a et 34b. Ainsi, lorsque les deux éléments 6a, 6b sont emboîtés, l'axe 6 est positionné et retenu axialement ; les molettes 61a et 61b sont munies extérieurement de quatre crans 66a facilitant l'action manuelle de l'utilisateur sur chacune des molettes.

Le couvercle 4 est fixé sur la partie supérieure du carter 3, de façon à protéger le segment 52 de l'organe applicateur 5 émergeant de l'ouverture 33 du carter 3 ; le couvercle 4 présente sur ses faces prolongeant les parois parallèles 21 du réservoir 2 des échancrures 42 en arc de cercle dans lesquels prennent place les molettes 61a, 61b en position de fermeture du couvercle 4.

L'ensemble 1 fonctionne de la façon suivante. Lorsque l'utilisateur désire prélever par exemple une poudre P contenue dans le réservoir 2, il enlève le couvercle et retourne l'ensemble 1 pour que la poudre P vienne par gravité en contact avec le segment 53 du disque 5. Ensuite, il fait tourner l'une des molettes 61a ou 61b d'un demi-tour, dans un sens ou dans l'autre, de façon que la partie du disque formant le segment 53 prenne la place correspondante au segment 52 dans l'ouverture 33. Pendant la rotation, le disque tasse la poudre entre les bords inclinés 32a. Le produit est ainsi compacté sur l'applicateur 5. Pour appliquer la poudre, l'utilisateur se sert du segment 52 émergeant du carter 3 comme applicateur. On comprendra qu'en faisant tourner le disque d'un angle plus ou moins grand, il est possible de doser à volonté la quantité de produit présente sur le segment 52 émergeant. Grâce à l'élasticité de la périphérie du disque 5 en mousse, le contact entre le disque 5 et le bord de l'ouverture 32 est suffisamment étanche pour que la poudre ne risque pas de s'échapper du réservoir au cours du stockage et quand on retourne l'ensemble pour mettre le produit en contact avec le segment 53 du disque.

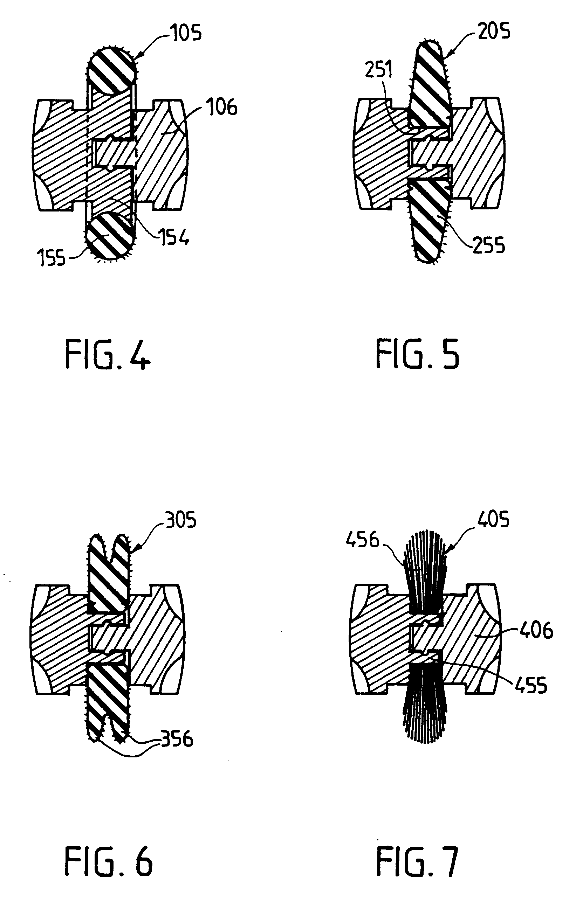

Les figures 4 à 7 représentent différents modes de réalisation du disque applicateur selon l'invention. Selon la figure 4, le disque 105 est constitué par un moyeu 154 solidaire de l'axe 106 sur lequel est fixé un anneau torique 155 en mousse souple floquée. Sur la figure 5, le disque 205 est également en mousse souple floquée 255 mais plus épais au voisinage de l'ouverture centrale 251 qu'à sa périphérie. Selon la figure 6, le disque 305 forme à la périphérie deux lèvres 356. Selon la figure 7, le disque 405 est constitué par un moyeu 455 faisant partie de l'axe 406 sur lequel sont fixés radialement des poils souples 456, qui peuvent être naturels, synthétiques, par exemple en élastomère naturel ou synthétique.

L'organe applicateur n'est pas, bien entendu, limité aux formes et constitutions décrites ci-dessus et représentées ; on comprendra que pour la mise en oeuvre de l'invention il suffit que l'organe applicateur soit solidaire d'un axe de rotation et constitué au moins d'un matériau ayant une certaine souplesse présentant en surface des cellules ouvertes dans lesquelles le produit à appliquer est compacté ; un tel matériau est par exemple un élastomère souple, ayant une dureté Shore A de l'ordre de 15 à 70 ; l'élastomère peut être vulcanisable, comme un silicone, un EPDM (terpolymère d'éthylène, de propylène et d'un diène), un latex ou autre, ou thermoplastique, comme un polyuréthane, un polyéther, un EVA (copolymère éthylène à acétate de vinyle) ou autre; les cellules ouvertes en surface peuvent être des microcratères ou des microstries radiales, concentriques, en hélice ou autres, ou obtenues par flocage à l'aide de fils en rayonne, coton, nylon ou autre, d'une longueur de un à quinze dixièmes de millimètre et de diamètre de l'ordre de trois centièmes de millimètre. Ledit matériau, pour l'organe applicateur, peut également être une mousse : la mousse, en élastomère synthétique ou naturel, peut être à cellules ouvertes ou fermées ; lorsque la mousse est à cellules fermées, les éléments utilisés pour la constitution de l'organe applicateur sont obtenus par tronçonnage d'un barreau cylindrique en une telle mousse, une telle opération ouvrant en surface les cellules fermées de la mousse.

L'organe applicateur peut être ausi composite: ainsi, lorsque la mousse ci-dessus est à cellules fermées, elle peut être sur l'une de ses faces transversales revêtue d'un tissu, d'un élastomère, d'un flocage, le revêtement ainsi réalisé constituant la face transversale d'application de l'organe applicateur ; bien entendu, les revêtements des deux faces d'application de l'organe applicateur peuvent être les mêmes ou différents ; lesdits revêtements peuvent aussi être associés à une mousse à cellules ouvertes : ceci permet de conférer, si nécessaire, à l'organe applicateur une flexibilité différente de celle obtenue avec une mousse à cellules fermées ; il est possible également pour ajuster la flexibilité de l'organe applicateur à une valeur souhaitée de prévoir in situ des éléments raidisseurs, pour limiter la déformation de l'organe applicateur lors de l'application du produit.

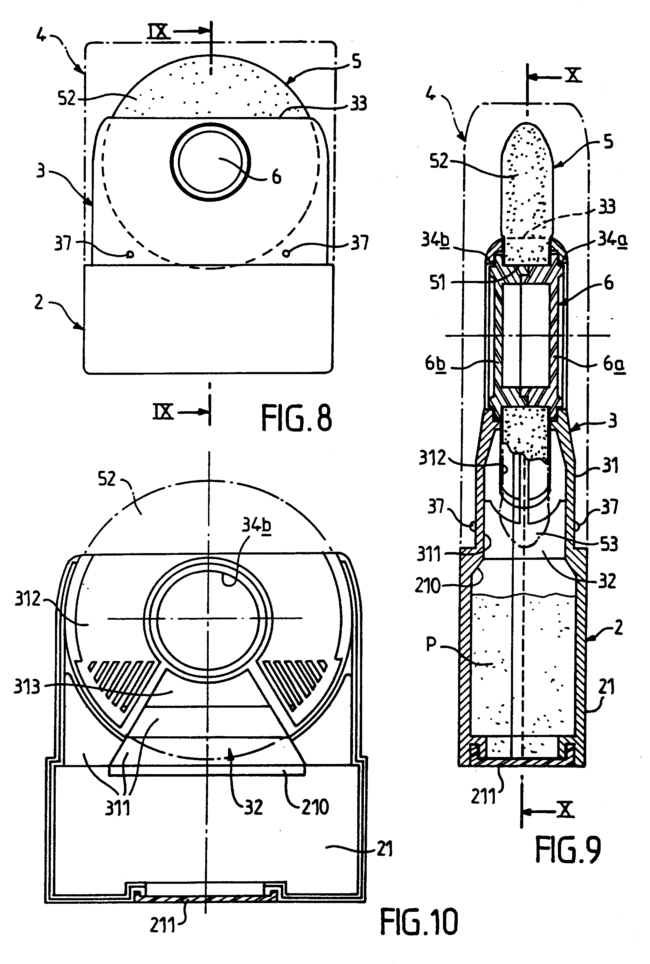

Les figures 8 à 10 représentent un autre mode de réalisation d'un ensemble selon l'invention ; sur ces figures, on a désigné par les mêmes références, les pièces ou parties de pièces identiques ou jouant le même rôle ; celles-ci ne seront donc pas entièrement décrites. Selon ce mode de réalisation, le sous-ensemble constitué par le réservoir 2 et le carter 3 est réalisé en deux pièces substantiellement symétriques et assemblées selon un plan de joint transversal par rapport à l'axe 6 ; cet assemblage est réalisé après mise en place de l'organe applicateur 5 et des éléments 6a, 6b constituant l'axe 6 ; un bouchon 211, à la partie inférieure du réservoir 2, permet le remplissage et/ou vidage du produit P ; un couvercle 4 ferme l'ensemble, le couvercle 4 étant maintenu par des picots de claquage 37 (figure 8) portés par le carter 3 ; un miroir, non représenté, collé sur la face extérieure du couvercle 4 facilite l'opération de maquillage, lorsque le produit P est un produit de maquillage ; le couvercle 4 comporte des évents, non représentés, facilitant sa mise en place en évitant un effet de piston.

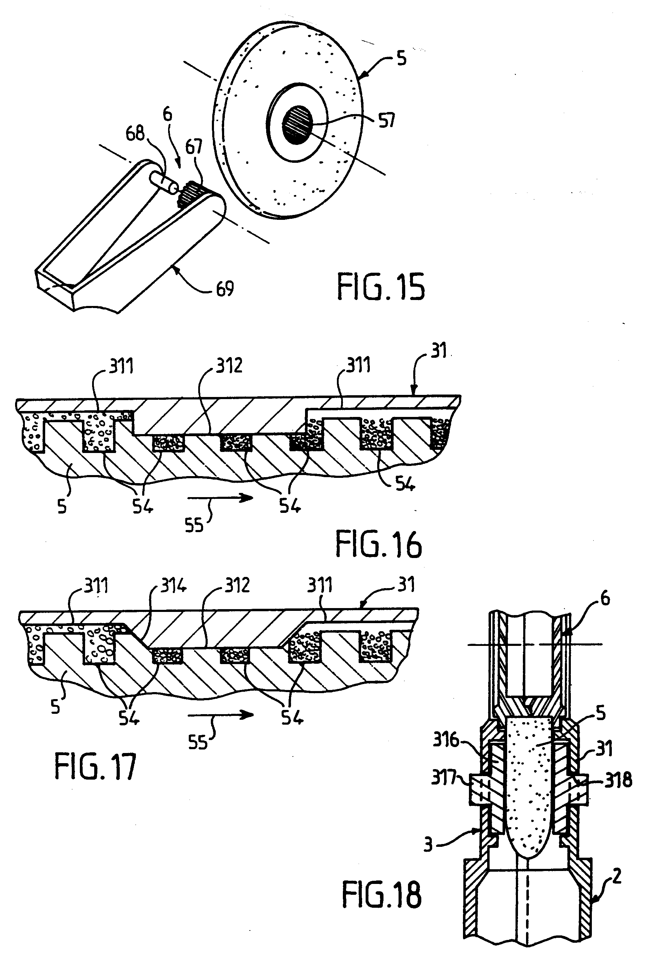

L'une des deux pièces constituant pour partie le réservoir 2 et pour partie le carter 3 est mieux visible sur la figure 10 ; ces pièces peuvent être réalisées par moulage de toute matière plastique appropriée, éventuellement transparente ; une telle matière peut être un polypropylène, un polyacétal, un polyester ; avantageusement, il peut y être adjoint un agent lubrifiant comme le bisulfure de molybdène minimisant le frottement dans la zone de précontrainte décrite ci-dessous ; ce peut être aussi du polytétrafluoroéthylène ; la paroi 21 délimitant le réservoir 2 se prolonge, au delà de l'ouverture intérieure 32, selon l'enveloppe 31 du carter 3 qui comprend des portions 311 placées, par rapport au plan de la figure 10, légèrement au dessus de la paroi 21, et une zone 312 placée, par rapport au même plan, au dessus des portions 311 ; des parois inclinées 313 et 210 raccordent localement les portions 311, respectivement, à la zone 312 et à la paroi 21 ; ainsi, comme cela est visible sur la figure 9, lorsque l'ensemble est monté, les zones 312 en regard sont à une distance l'une de l'autre inférieure à l'épaisseur axiale de l'organe applicateur 5 souple, ladite épaisseur étant mesurée lorsque l'organe applicateur 5 est libre, au repos, qui est celle, notamment, de la portion du segment 52 qui dépasse, à l'extérieur, l'ouverture extérieure 33 ; l'organe applicateur 5 est dès lors comprimé au droit des zones 312 ; ainsi, lorsque l'organe applicateur 5 est tourné par son axe 6, dans le sens de la flèche 55 sur la figure 16, les cellules ouvertes 54 et le produit avoisinant sont comprimés au passage de la zone 312 et le produit se trouve compacté dans les cellules 54 à la sortie de la zone 312, lesdites cellules 54 retrouvant alors leur forme initiale grâce à la mémoire de forme du matériau constituant l'organe applicateur ; la figure 17 montre une variante selon laquelle cette compression est effectuée progressivement grâce à l'existence d'un raccordement incliné progressif 314 existant entre la portion plane 311 et la zone 312.

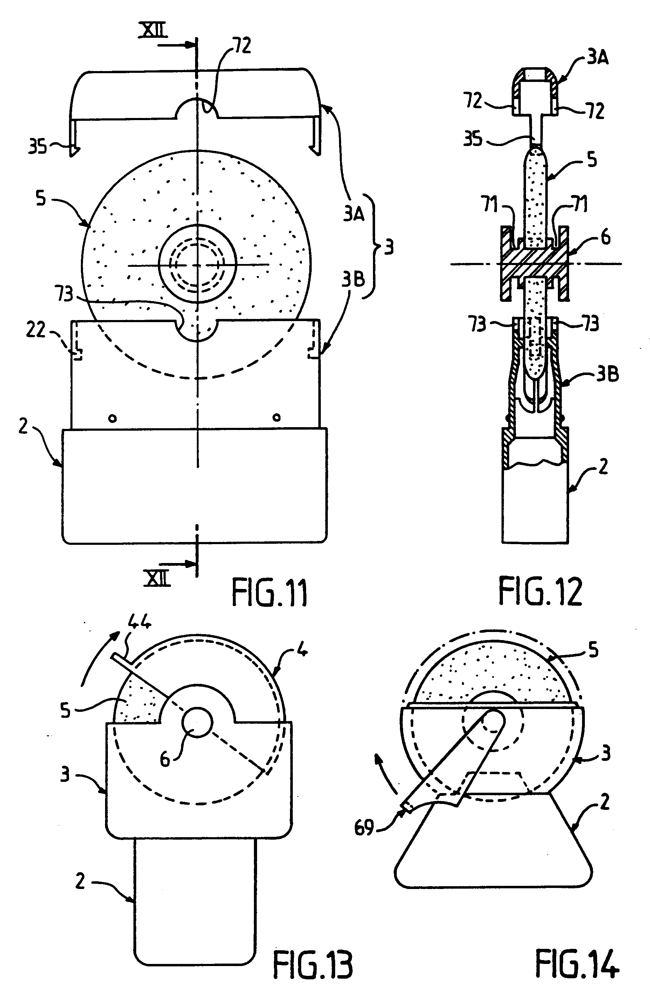

Selon la variante des figures 11 et 12, le carter 3 est en deux pièces 3A et 3B que l'on peut assembler par des dispositifs de fixation par claquage 35 et 22 ; les parois latérales des deux pièces 3A et 3B portent respectivement des échancrures 72 et 73 dont les bords coopèrent avec des gorges 71 de tourillonnement portées par l'axe 6 ; de cette manière, l'organe applicateur 5 est aisément interchangeable.

Selon la figure 13, le couvercle 4 de forme semi-cylindrique est, comme l'organe applicateur 5, solidaire de l'axe 6 ; une languette radiale 44 de préhension permet l'ouverture et la fermeture du couvercle 4 par rotation ; lors de ces mouvements de rotation, l'organe applicateur 5 est chargé en produit, comme décrit ci-dessus; on comprendra que, dans une telle réalisation, il n'est pas nécessaire que l'organe applicateur 5 soit un disque complet : il peut en effet être limité à un segment ou secteur semi-circulaire.

Suivant la variante des figures 14 et 15, le dispositif d'actionnement de l'organe applicateur 5 est un levier extérieur 69 en forme de U dont les branches portent à leur extrémité, l'une des dentures extérieures 67, l'autre un pion de clipsage 68 ; les dentures extérieures 67 matérialisent l'axe 6 et reçoivent les dentures intérieures 57 de l'organe applicateur 5 en forme de disque avant fermeture du levier 69 par clipsage du pion 68.

La figure 18 montre une variante dans laquelle la mise en contrainte de l'organe applicateur 5 est obtenue en disposant des plateaux de pression 316 entre l'organe applicateur 5 et les parois de l'enveloppe 31 ; les plateaux de pression 316 sont solidaires d'un bouton-poussoir 317 traversant des passages 318 ménagés dans les parois de l'enveloppe 31 ; ainsi, par pression dosée sur les boutons-poussoirs 317, l'utilisateur peut faire varier, à volonté, la mise en contrainte de l'organe applicateur 5. Selon une variante non représentée, les plateaux de pression 316 n'ont pas de bouton-poussoir et sont montés dans l'enveloppe à la manière de cales d'épaisseur: ainsi, par construction, en choisissant l'épaisseur d'un plateau, la précontrainte de l'organe applicateur peut être variable et fixée à une valeur souhaitée, simplement en changeant le plateau de pression.

Selon une autre variante non représentée, le réservoir est divisé en deux compartiments par une cloison s'étendant dans le plan de l'organe applicateur, les deux compartiments contenant deux produits différents, chacun étant associé à l'une des faces de l'organe applicateur.

## Revendications

1. Ensemble applicateur d'un produit cosmétique, comportant un réservoir (2) contenant le produit et un organe applicateur (5, 105, 205, 305, 405), constitué d'au moins un segment (53) circulaire en matériau souple, solidaire en rotation d'un axe (6) par lequel il est monté en rotation dans un carter (3), solidaire du réservoir (2) contenant le produit, ledit axe (6) pouvant être actionné en rotation de l'extérieur, ensemble dans lequel le carter (3) comporte deux ouvertures (32, 33), une ouverture (32) intérieure, mettant en communication le réservoir (2) et le carter (3), et une ouverture (33) extérieure, s'ouvrant vers l'extérieur, l'organe applicateur (5, 105, 205, 305, 405) étant monté mobile entre au moins deux positions, une position permettant le contact du segment (53) de l'organe applicateur (5, 105, 205, 305, 405) avec le produit contenu dans le réservoir (2) et une position où ledit segment (53) chargé de produit est au moins partiellement mis au droit de l'ouverture extérieure (33) pour lui permettre d'émerger du carter (3) et de servir pour l'application du produit, l'organe applicateur (5, 105, 205, 305, 405) ayant tendance en passant, par rotation, de l'une à l'autre desdites positions à tasser le produit qui se trouve ainsi compacté sur l'organe applicateur (5, 105, 205, 305, 405) caractérisé par le fait que le segment (53) dudit organe applicateur (5, 105, 205, 305, 405) est au moins en partie comprimé dans la direction de l'axe (6) de rotation dans une zone (312) comprise entre les ouvertures intérieure (32) et extérieure (33).

2. Ensemble applicateur selon la revendication 1, caractérisé par le fait que le carter (3) est constitué par une enveloppe (31) dont les parois latérales sont, au droit de ladite zone, à une distance l'une de l'autre inférieure à l'épaisseur axiale du segment (53) de l'organe applicateur (5, 105, 205, 305, 405) souple, ladite épaisseur étant mesurée lorsque l'organe applicateur (5, 105, 205, 305, 405) est libre, au repos.

3. Ensemble applicateur selon la revendication 1, caractérisé par le fait que le carter (3) est constitué par une enveloppe (31) et au moins un plateau de pression (316) est disposé axialement entre une paroi latérale de l'enveloppe (31) et le segment (53) de l'organe applicateur (5, 105, 205, 305, 405).

4. Ensemble applicateur selon la revendication 3, caractérisé par le fait que le plateau de pression (316) est solidaire d'un bouton-poussoir (317) traversant la paroi latérale de l'enveloppe (31).

5. Ensemble applicateur selon l'une des revendications 1 à 4, caractérisé par le fait que le carter (3) est constitué par une enveloppe (31), l'ouverture (32) inférieure étant ménagée sur le bord inférieur de l'enveloppe (31) et comportant des échancrures ménagées dans les parois latérales de l'enveloppe (31), le bord (32a) de l'ouverture (32) inférieure ayant la forme d'un biseau incliné de l'extérieur vers l'intérieur sur tout le pourtour de l'ouverture (32) inférieure, ledit segment (53) de l'organe applicateur (5, 105, 205, 305, 405) étant disposé au droit desdites échancrures.

6. Ensemble applicateur selon l'une des revendications 1 à 5, caractérisé par le fait qu'il comporte un couvercle (4) monté sur le carter (3).

7. Ensemble applicateur selon l'une des revendications 1 à 6, caractérisé par le fait que l'organe applicateur (5, 205) est entièrement constitué d'une mousse souple.

8. Ensemble applicateur selon l'une des revendications 1 à 6, caractérisé par le fait que l'organe applicateur (205) est réalisé en un matériau thermoplastique semi-souple ayant subi un traitement de surface de floquage.

9. Ensemble applicateur selon l'une des revendications 1 à 6, caractérisé par le fait que l'organe applicateur (105) est constitué par un moyeu circulaire (154) en matériau rigide sur lequel est fixé un anneau (155) en mousse souple.

10. Ensemble applicateur selon l'une des revendications 7 ou 9, caractérisé par le fait que la surface en mousse souple de l'organe applicateur est au moins partiellement floquée.

11. Ensemble applicateur selon l'une des revendications 1 à 6, caractérisé par le fait que l'organe applicateur est constitué d'un moyeu en matériau rigide (455) sur lequel des poils souples (456) sont fixés radialement.

12. Ensemble applicateur selon l'une des revendications 1 à 11, caractérisé par le fait que le dispositif d'actionnement en rotation de l'organe applicateur (5, 105, 205, 305, 405) est constitué par au moins une molette (61a, 61b) solidaire de l'axe (6) disposée au moins partiellement extérieurement au carter (3).

13. Ensemble applicateur selon l'une des revendications 1 à 11, caractérisé par le fait que le dispositif d'actionnement est le couvercle (4) lui-même monté à rotation et solidaire de l'organe applicateur (5, 105, 205, 305, 405).

14. Ensemble applicateur selon l'une des revendications 1 à 11, caractérisé par le fait que le dispositif d'actionnement est un levier extérieur (69).

15. Ensemble applicateur selon la revendication 14, caractérisé par le fait que le carter (3) est en deux pièces (3A, 3B) et l'organe applicateur (5, 105, 205, 305, 405) est monté de manière amovible.

## Claims

1. Applicator assembly for a cosmetic product, comprising a container (2) holding the product, and an applicator device (5, 105, 205, 305, 405) consisting of at least one circular segment (53) made of flexible material, integral in terms of rotation with a spindle (6) by means of which it is mounted rotatably in a casing (3) which is integral with the container (2) holding the product, it being possible for the said spindle (6) to be set in rotation from the outside, the casing (3) of which assembly comprises two openings (32, 33), an inner opening (32) establishing a communication between the container (2) and the casing (3), and an outer opening (33) which opens towards the outside, the applicator device (5, 105, 205, 305, 405) being mounted movably between at least two positions, one position allowing the segment (53) of the applicator device (5, 105, 205, 305, 405) to come into contact with the product held in the container (2), and one position in which the said segment (53), charged with product, is at least partially brought into line with the outer opening (33) in order to allow it to emerge from the casing (3) and serve for application of the product, the applicator device (5, 105, 205, 305, 405) having a tendency, as it passes by means of rotation from one to the other of the said positions, to pack the product, which is therefore compacted on the applicator device (5, 105, 205, 305, 405), characterized by the fact that the segment (53) of the said applicator device (5, 105, 205, 305, 405) is at least partially compressed in the direction of the rotation spindle (6) in a zone (312) between the inner opening (32) and outer opening (33).

2. Applicator assembly according to Claim 1, characterized by the fact that the casing (3) consists of a shell (31) whose side walls are, in line with the said zone, at a distance from one another which is smaller than the axial thickness of the segment (53) of the flexible applicator device (5, 105, 205, 305, 405), the said thickness being measured when the applicator device (5, 105, 205, 305, 405) is free, not in use.

3. Applicator assembly according to Claim 1, characterized by the fact that the casing (3) consists of a shell (31), and at least one pressure plate (316) is arranged axially between a side wall of the shell (31) and the segment (53) of the applicator device (5, 105, 205, 305, 405).

4. Applicator assembly according to Claim 3, characterized by the fact that the pressure plate (316) is integral with a push-button (317) passing through the side wall of the shell (31).

5. Applicator assembly according to one of Claims 1 to 4, characterized by the fact that the casing (3) consists of a shell (31), the lower opening (32) being formed on the lower edge of the shell (31) and comprising notches formed in the side walls of the shell (31), the edge (32a) of the lower opening (32) having the shape of a bevel inclined from the outside towards the inside over the entire perimeter of the lower opening (32), the said segment (53) of the applicator device (5, 105, 205, 305, 405) being arranged in line with the said notches.

6. Applicator assembly according to one of Claims 1 to 5, characterized by the fact that it comprises a cap (4) fitted on the casing (3).

7. Applicator assembly according to one of Claims 1 to 6, characterized by the fact that the applicator device (5, 205) consists entirely of a flexible foam.

8. Applicator assembly according to one of Claims 1 to 6, characterized by the fact that the applicator device (205) is made of a semi-flexible thermoplastic which has undergone a surface flocking treatment.

9. Applicator assembly according to one of Claims 1 to 6, characterized by the fact that the applicator device (105) consists of a circular hub (154) of rigid material, on which a ring (155) of flexible foam is fixed.

10. Applicator assembly according to either of Claims 7 and 9, characterized by the fact that the flexible foam surface of the applicator device is at least partially flocked.

11. Applicator assembly according to one of Claims 1 to 6, characterized by the fact that the applicator device consists of a hub of rigid material (455) on which flexible hairs (456) are radially fixed.

12. Applicator assembly according to one of Claims 1 to 11, characterized by the fact that the means for activating the applicator device (5, 105, 205, 305, 405) in rotation consists of at least one knurled wheel (61a, 61b) integral with the spindle (6) arranged at least partially outside the casing (3).

13. Applicator assembly according to one of Claims 1 to 11, characterized by the fact that the activating means is the cap (4) itself, fitted rotatably and integral with the applicator device (5, 105, 205, 305, 405).

14. Applicator assembly according to one of Claims 1 to 11, characterized by the fact that the activating means is an external lever (69).

15. Applicator assembly according to Claim 14, characterized by the fact that the casing (3) is made in two parts (3A, 3B) and the applicator device (5, 105, 205, 305, 405) is mounted in a removable manner.

## Patentansprüche

1. Auftragsvorrichtung für ein kosmetisches Produkt, die einen das Produkt enthaltenden Behälter (2) und ein Auftragselement (5,105,205,305,405) aufweist, das aus wenigstens einem Kreissegment (53) aus weichem Material besteht und drehfest mit einer Achse (6) verbunden ist, mit der es drehbar in einem Gehäuse (3) montiert ist, das mit dem das Produkt enthaltenden Behälter (2) verbunden ist, wobei die Achse (6) von außen in Rotation versetzt werden kann, wobei das Gehäuse (3) zwei Öffnungen (32,33) aufweist, eine innere Öffnung (32), die eine kommunizierende Verbindung zwischen dem Behälter (2) und dem Gehäuse (3) herstellt, und eine äußere Öffnung (33), die sich nach außen öffnet, wobei das Auftragselement (5,105,205,305,405) beweglich zwischen wenigstens zwei Positionen angebracht ist, nämlich einer Position, die den Kontakt des Segments (53) des Auftragselements (5,105,205,305,405) mit dem in dem Behälter (2) enthaltenen Produkt ermöglicht, und einer Position, in der sich das mit dem Produkt beladene Segment (53) wenigstens teilweise an der äußeren Öffnung (33) befindet, um ihm den Austritt aus dem Gehäuse (3) zu gestatten und das Auftragen des Produktes zu ermöglichen, wobei das Auftragselement (5,105,205,305,405) bei der Drehung von einer dieser Positionen in die andere Position dazu neigt, das Produkt zusammenzudrücken, das sich so kompaktiert auf dem Auftragselement (5,105,205,305,405) befindet, dadurch gekennzeichnet, daß das Segment (53) des Auftragselements (5,105,205,305,405) in einem zwischen der inneren Öffnung (32) und der äußeren Öffnung (33) befindlichen Bereich (312) wenigstens teilweise in Richtung der Drehachse (6) komprimiert ist.

2. Auftragsvorrichtung gemäß Anspruch 1, dadurch gekennzeichnet, daß das Gehäuse (3) aus einer Hülle (31) besteht, deren Seitenwände sich in diesem Bereich in einer Entfernung voneinander befinden, die kleiner als die axiale Dicke des Segmentes (53) des weichen Auftragselements (5,105,205,305,405) ist, wobei die Dicke gemessen wird, wenn das Auftragselement (5,105,205,305,405) im Ruhezustand frei ist.

3. Auftragsvorrichtung gemäß Anspruch 1, dadurch gekennzeichnet, daß das Gehäuse (3) aus einer Hülle (31) besteht und wenigstens eine Druckplatte (316) axial zwischen einer Seitenwand der Hülle (31) und dem Segment (53) des Auftragselements (5,105,205,305,405) angeordnet ist.

4. Auftragsvorrichtung gemäß Anspruch 3, dadurch gekennzeichnet, daß die Druckplatte (316) mit einem Druckknopf (317) verbunden ist, der die Seitenwand der Hülle (31) durchquert.

5. Auftragsvorrichtung gemäß einem der Ansprüche 1 bis 4, dadurch gekennzeichnet, daß das Gehäuse (3) aus einer Hülle (31) besteht, wobei die untere Öffnung (32) im unteren Rand der Hülle (31) ausgespart ist und Ausschnitte aufweist, die in die Seitenwände der Hülle (31) eingebracht sind, wobei der Rand (32a) der unteren Öffnung (32) auf dem gesamten Außenumfang der unteren Öffnung (32) die Form einer von außen nach innen geneigten Schräge aufweist, wobei das Segment (53) des Auftragselements (5,105,205,305,405) bei diesen Ausschnitten angeordnet ist.

6. Auftragsvorrichtung gemäß einem der Ansprüche 1 bis 5, dadurch gekennzeichnet, daß sie einen auf dem Gehäuse (3) angebrachten Deckel (4) aufweist.

7. Auftragsvorrichtung gemäß einem der Ansprüche 1 bis 6, dadurch gekennzeichnet, daß das Auftragselement (5,205) vollständig aus einem weichen Schaumstoff besteht.

8. Auftragsvorrichtung gemäß einem der Ansprüche 1 bis 6, dadurch gekennzeichnet, daß das Auftragselement (205) aus einem halbweichen thermoplastischen Material besteht, das einer Oberflächenbehandlung durch Beflockung unterzogen wurde.

9. Auftragsvorrichtung gemäß einem der Ansprüche 1 bis 6, dadurch gekennzeichnet, daß das Auftragselement (105) aus einer kreisförmigen Nabe (154) aus starrem Material besteht, auf der ein Ring (155) aus weichem Schaumstoff befestigt ist.

10. Auftragsvorrichtung gemäß einem der Ansprüche 7 oder 9, dadurch gekennzeichnet, daß die Schaumstoffoberfläche des Auftragselements wenigstens teilweise beflockt ist.

11. Auftragsvorrichtung gemäß einem der Ansprüche 1 bis 6, dadurch gekennzeichnet, daß das Auftragselement aus einer Nabe (455) aus starrem Material besteht, auf der weiche Härchen (456) radial befestigt sind.

12. Auftragsvorrichtung gemäß einem der Ansprüche 1 bis 11, dadurch gekennzeichnet, daß die Betätigungseinrichtung für die Drehbewegung des Auftragselements (5,105,205,305,405) aus wenigstens einem mit der Achse (6) verbundenen Rädchen (61a, 61b) besteht, das wenigstens teilweise außerhalb des Gehäuses (3) angeordnet ist.

13. Auftragsvorrichtung gemäß einem der Ansprüche 1 bis 11, dadurch gekennzeichnet, daß die Betätigungseinrichtung der Deckel (4) selbst ist, der drehbar und mit dem Auftragselement (5,105,205,305,405) verbunden montiert ist.

14. Auftragsvorrichtung gemäß einem der Ansprüche 1 bis 11, dadurch gekennzeichnet, daß die Betätigungseinrichtung ein externer Hebel (69) ist.

15. Auftragsvorrichtung gemäß Anspruch 14, dadurch gekennzeichnet, daß das Gehäuse (3) aus zwei Teilen (3A,3B) besteht und das Auftragselement (5,105,205,305,405) abnehmbar montiert ist.
